# EUROPEAN PATENT SPECIFICATION

(11) **EP 0 762 589 B1**
(45) Date of publication and mention of the grant of the patent: **15.12.1999**
(21) Application number: 96202349.5
(22) Date of filing: 23.08.1996
(51) Int. Cl.: H02G 13/00, G01R 11/24, G01R 13/06

(54) **Device for recording strokes of lightning**
Blitzschlagaufnahmeanlage
Dispositif d'enregistrement de coups de foudre

(30) Priority: 23.08.1995 NL 1001035
(43) Date of publication of application: 12.03.1997
(73) Proprietor: Van der Heide Beheer B.V., 9291 MB Kollum (NL)
(72) Inventor: Pols, Edward, 9285 MA Buitenpost (NL)
(74) Representative: 't Jong, Bastiaan Jacobus

(56) References cited:
- FR-A- 2 497 957
- US-A- 4 105 966
- PATENT ABSTRACTS OF JAPAN vol. 11, no. 216 (P-595), 14 July 1987 & JP-A-62 034071 (TOSHIBA CORP), 14 February 1987,

## Description

The present invention relates to a device for recording strokes of lightning which comprises: a lightning conductor, a detection circuit connected to the lightning conductor, recording equipment to be set into operation in response to a lightning stroke, and protection means to prevent recording of incorrect data.

Such a device is known from US-A-4,105,966, wherein the detection circuit is designed as a coil connected inductively to the lightning conductor and the recording equipment is designed as a transient memory. The transient memory herein increases the count value when a current is induced in the coil connected to the counter by a current flowing through the lightning conductor which is the consequence of a direct lightning stroke. The protection means comprise a shield against radiofrequency interference and is thus comparable with a Faraday-cage.

Such a device for recording lightning strokes is desirable in order to be able to demonstrate that damage to for instance electronic equipment in a building caused by a lightning stroke can actually be attributed to a lightning stroke. However, in the above described configuration the known devices for recording lightning strokes are unreliable, in that they are particularly susceptible to fraud, against which the protection means provide no relief at all. As the devices are susceptible to fraud the count value can be increased in fraudulent manner, leading for example to unjustified insurance claims in relation to damages allegedly caused by lightning.

The present invention has for its object to obviate the above stated disadvantages of prior devices and provides to this end a device which is distinguished in that said protection means comprise a housing enclosing inaccessibly at least the detection circuit, and communication means for transfer of lightning data.

A device according to the present invention is preferably such that the protection means comprise a comparing circuit for comparing the lightning data with a threshold value, wherein the recording equipment and comparing equipment are adapted to record the lightning data at a value of the lightning data exceeding the threshold value.

As a result hereof sensitivity to shocks is eliminated and fraud in this manner is no longer possible. Recording of a lightning stroke is moreover made dependent on the intensity of the lightning stroke since a threshold value has been set. It is therefore possible not to record lightning strokes normally of a strength not causing damage or it is alternatively possible to record the strength of each lightning stroke. A device according to the invention preferably contains a converting circuit for converting the signal from the detection circuit containing the lightning data. The converting circuit is for instance designed as a measuring instrument for measuring the current induced in the coil, wherein the strength of the lightning stroke can be derived from the magnitude of the current induced in the coil.

A signal from the coil can be transferred over a certain distance to another part of the device, which part may or may not be situated in the same housing, to be there compared with a threshold value or to be directly recorded, wherein in the latter case comparison takes place at a later stage.

Since recording of more lightning data than only one count value is desirable, the device according to the invention is preferably such that the recording equipment comprises a memory element.

It may be desirable for the date and time of each lightning stroke to be recorded, wherein the device contains clock means and wherein the comparing circuit and the memory element are adapted to record and add to lightning data dates and times provided by the clock means.

The device preferably contains a separate reading unit, wherein the communication means and the reading unit each comprise transmitting means and receiving means for transfer of data. The communication means and the reading unit preferably exchange data and communication data for control of the data flows in a very specific manner so that unauthorized reading of the recorded lightning data with equipment other than the reading unit specifically intended for this purpose is not possible.

The invention is further elucidated with reference to the following figure description of an embodiment of the invention. In the drawing:
fig. 1 shows an example of a location where a device according to the present invention can be placed; and
fig. 2 shows a schematic view of a device according to the present invention, wherein a reading unit is also shown.

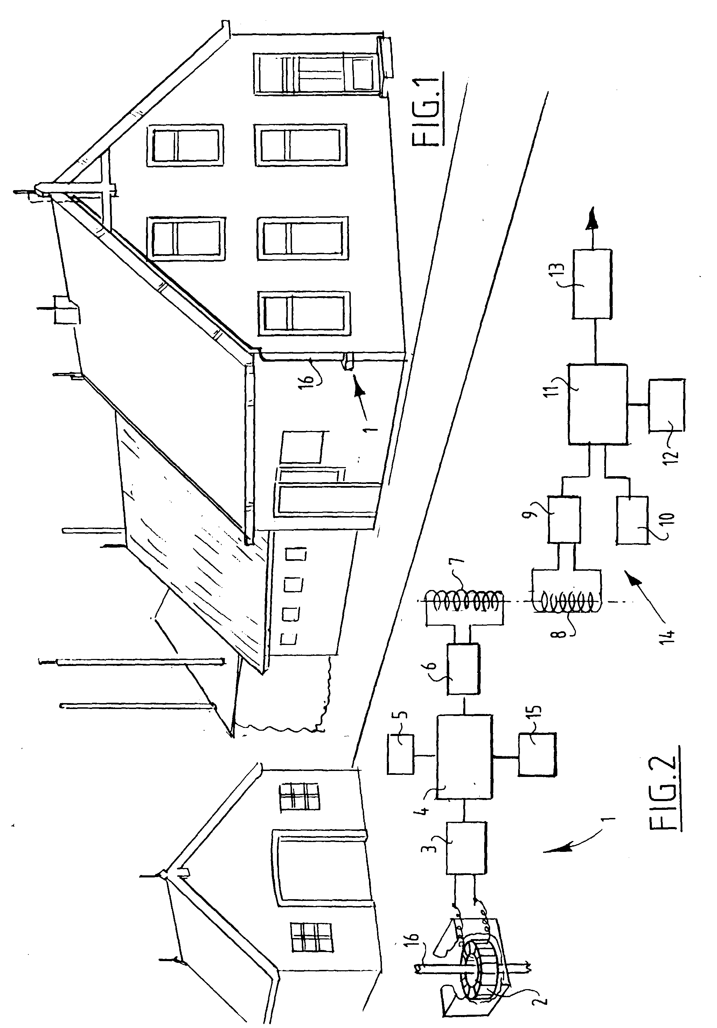

Shown in fig. 1 is a residential dwelling which is provided with an installation containing lightning conductors 16 for discharging lightning strokes. The device, which is coupled inductively to lightning conductor 16, is designated 1 in the figure.

The device 1 is shown schematically in fig. 2, as is a separate reading unit 14. The device shown in fig. 2 as embodiment of the invention comprises: a detection circuit designed as a coil 2; a converting circuit designed as measuring instrument 3; a comparing circuit designed as processing unit 4; recording equipment designed as memory element 5; clock means designed as clock 15; and communication means designed as transmitter 6 with aerial coil 7.

In the figure the coil 2 is connected to measuring instrument 3, so that a current occurring in lightning conductor 16 during a lightning stroke causes an induced current in coil 2, the strength of which is determined by measuring instrument 3. It is herein possible for measuring instrument 3 to determine the value of the current flowing through conductor 16 from the recorded value of the current induced in coil 2. The result of the measurement by measuring instrument 3 is sent to the processing unit 4 where this measurement value is compared with a threshold value in order to determine whether a lightning stroke has actually occurred. If the measurement value is for instance higher than the threshold value, whereby the answer to this question is in the affirmative, a count value in the memory element is increased. In memory element 5 a list of previous lightning strokes is further supplemented with lightning data relating to this last lightning stroke. The lightning data comprises for instance the strength of the current induced in coil 2 and running through lightning conductor 16 and/or the date and time of the lightning stroke, wherein the date and time are read from the clock 15 by processing unit 4 and subsequently stored in memory element 5.

In order to increase the reliability of the device it is also possible to record other lightning data in memory element 5, such as a barometric pressure which is valid at the moment of an alleged lightning stroke and which can also be read by processing unit 4 from a barometer (not shown).

Using the aerial coil 7 and the transmitter 6 the lightning data recorded in memory element 5 can be read via processing unit 4 using the separate reading unit 14. This latter comprises an aerial coil 8; a transmitter 9; a clock 10; a control circuit designed as processing unit 11; a memory element 12; and an interface 13.

Communication with the device 1 is realized using the aerial coil 8 and transmitter 9, and is controlled by processing unit 11 which is connected to transmitter 9 and via transmitter 9 to the aerial coil 8. This communication preferably takes place in coded manner so that it is not possible to perform any unauthorized reading of memory element 5 of device 1, i.e. without reading unit 14. The lightning data transferred by device 1 from the memory 5 via transmitter 6 and aerial coil 7 and then via aerial coil 8 and transmitter 9 to processing unit 11 is stored in a memory element 12 connected to processing unit 11. As a result of the above described configuration of device 1 and reading unit 14 it is possible that a number of devices 1 can be read with one reading unit 14. Reading unit 14 is designed in this case as a hand-held instrument, wherein the lightning data stored in memory element 12 can be transferred via processing unit 11 and an interface 13 to other equipment such as a computer or a printer.

In the reading unit 14 the clock 10 is placed in connection with processing unit 11 so that during communication between device 1 and reading unit 14 the current date and time can be transferred to the device, wherein the clock 15, which may be wrong, takes up this current date and time from the device and adapts itself thereto so that this clock 15 will again run on time.

In an alternative embodiment it is also possible for each measurement value measured by measuring instrument 3 to be stored in memory element 5 and to be compared only at a later stage with a threshold value. This threshold value comparison can then take place for instance during reading of the lightning data by reading unit 14 or when this reading unit 14 transfers the lightning data stored in the memory element 12 thereof via interface 13 to a computer, or even later still.

The recording device can contain a battery or similar supply source for power supply. It is for instance possible herein that such a supply source is connected to the coil 2 or the lightning conductor 16 and can be recharged from the current induced in coil 2 or flowing through lightning conductor 16.

When the threshold value is set at a current of 600 A flowing through lightning conductor 16, it can be assumed that an incident wherein the threshold value comparison shows that the value for comparison is greater than the threshold value of 600 A does in fact constitute a lightning stroke.

Although the invention is described here on the basis of one embodiment, the invention is not limited thereto since many other embodiments and variants are possible within the scope of the claims following hereinbelow.

## Claims

1. Device (1) for recording strokes of lightning which comprises: a lightning conductor (16), a detection circuit (2) connected to the lightning conductor (16); recording equipment (5) to be set into operation in response to a lightning stroke; and protection means to prevent recording of incorrect data, **characterized** in that said protection means comprise a housing (fig. 1) enclosing inaccessibly at least the detection circuit (2), and communication means (6, 7) for transfer of lightning data.

2. Device as claimed in claim 1, **characterized by** a comparing circuit (4) for comparing the lightning data with a threshold value, wherein the recording equipment (5) and comparing equipment (4) are adapted to record the lightning data at a value of the lightning data exceeding the threshold value.

3. Device as claimed in claim 1 or 2, **characterized by** a converting circuit (3) for converting the signal from the detection circuit (2) containing the lightning data for transfer of the lightning data.

4. Device as claimed in claim 2 or 3, **characterized in that** the recording equipment (5) comprises a memory element.

5. Device as claimed in claim 4, **characterized by** clock means (15), wherein the comparing circuit (4) and the memory element (5) are adapted to record dates and times of lightning data provided by the clock means (15).

6. Device as claimed in any of the foregoing claims, **characterized by** a separate reading unit (14), wherein the communication means (6, 7) and the reading unit (14) each comprise transmitting means (7, 8) and receiving means (7, 8) for transfer of data.

7. Device as claimed in claim 6, **characterized in that** the communication means (6, 7) and the reading unit (14) are each adapted for remote transfer of lightning data.

8. Device as claimed in claim 6 or 7, **characterized in that** the communication means (6, 7) and the reading unit (14) are adapted for coded transfer of recorded data.

9. Device as claimed in claim 6, 7 or 8, **characterized in that** the reading unit (14) contains a control circuit (11) for at least controlling the transfer of data.

10. Device as claimed in any of the foregoing claims, **characterized by** a supply source for power supply to the device (1) which is connected to the lightning conductor (16) and is rechargeable from the energy from a lightning stroke.

## Patentansprüche

1. Vorrichtung (1) zum Aufzeichnen von Blitzschlägen mit: einem Blitzableiter (16), einer Erfassungsschaltung (2), die mit dem Blitzableiter (16) verbunden ist; einer Aufzeichnungseinrichtung (5), welche als Reaktion auf einen Blitzschlag in Betrieb gesetzt wird; und einem Schutzmittel zum Verhindern des Aufzeichnens fehlerhafter Daten; dadurch gekennzeichnet, daß das Schutzmittel ein Gehäuse (Fig. 1), das unzugänglich mindestens die Erfassungsschaltung (2) einschließt, und ein Kommunikationsmittel (6, 7) für die Übertragung von Blitzdaten aufweist.

2. Vorrichtung nach Anspruch 1, gekennzeichnet durch eine Vergleichsschaltung (4) zum Vergleichen der Blitzdaten mit einem Schwellenwert, wobei die Aufzeichnungseinrichtung (5) und die Vergleichseinrichtung (4) angepaßt sind, um die Blitzdaten bei einem Wert der Blitzdaten, der den Schwellenwert übersteigt, aufzuzeichnen.

3. Vorrichtung nach Anspruch 1 oder 2, gekennzeichnet durch eine Umwandlungsschaltung (3) zum Umwandeln des Signals von der Erfassungsschaltung (2), die die Blitzdaten enthält, für die Übertragung der Blitzdaten.

4. Vorrichtung nach Anspruch 2 oder 3, dadurch gekennzeichnet, daß die Aufzeichnungseinrichtung (5) ein Speicherelement enthält.

5. Vorrichtung nach Anspruch 4, gekennzeichnet durch ein Zeitgebermittel (15) wobei die Vergleichsschaltung (4) und das Speicherelement (5) angepaßt sind, um durch das Zeitgebermittel (15) gelieferte Daten und Zeiten der Blitzdaten aufzuzeichnen.

6. Vorrichtung nach einem der vorhergehenden Ansprüche, gekennzeichnet durch eine getrennte Leseeinheit (14), bei der das Kommunikationsmittel (6, 7) und die Leseeinheit (14) jeweils ein Übertragungsmittel (7, 8) und ein Empfangsmittel (7, 8) zum Übertragen von Daten aufweisen.

7. Vorrichtung nach Anspruch 6, dadurch gekennzeichnet, daß das Kommunikationsmittel (6, 7) und die Leseeinheit (14) jeweils für eine Fernübertragung von Blitzdaten angepaßt sind.

8. Vorrichtung nach Anspruch 6 oder 7, dadurch gekennzeichnet, daß das Kommunikationsmittel (6, 7) und die Leseeinheit (14) für eine kodierte Übertragung von aufgenommenen Daten angepaßt sind.

9. Vorrichtung nach Anspruch 6, 7 oder 8, dadurch gekennzeichnet, daß die Leseeinheit (14) eine Steuerschaltung (11) mindestens zum Steuern der Übertragung der Daten enthält.

10. Vorrichtung nach einem der vorhergehenden Ansprüche, gekennzeichnet durch eine Versorgungsquelle für die Leistungsversorgung an die Vorrichtung (1), welche mit dem Blitzableiter (16) verbunden ist und von der Energie eines Blitzschlages wiederaufladbar ist.

## Revendications

1. Dispositif (1) destiné à enregistrer des coups de foudre se composant d'un conducteur de foudre (16), un circuit de détection (2) connecté au conducteur de coup de foudre (16); d'un matériel d'enregistrement (5) destiné à se déclencher en réponse à un coup de foudre; et d'un dispositif de protection destiné à empêcher l'enregistrement de données erronées, caractérisé en ce que ledit dispositif de protection comporte un boîtier (fig. 1) rendant inaccessible au moins le circuit de détection (2) et le dispositif de communication (6, 7) pour le transfert des données des coups de foudre.

2. Dispositif selon la revendication 1, caractérisé par un circuit de comparaison (4) destiné à comparer les données des coups de foudre avec une valeur seuil, dans lequel le matériel d'enregistrement (5) et le matériel de comparaison (4) sont conçus pour enregistrer les données des coups de foudre à une valeur supérieure à la valeur seuil.

3. Dispositif selon l'une des revendications 1 ou 2, caractérisé par un circuit de conversion (3) destiné à convertir le signal provenant du circuit de détection (2) contenant les données des coups de foudre afin de transférer lesdites données.

4. Dispositif selon la revendication 2 ou 3, caractérisé en ce que le matériel d'enregistrement (5) comprend une mémoire.

5. Dispositif selon la revendication 4, caractérisé par un dispositif d'horloge (15) comportant le circuit de comparaison (4) et la mémoire (5) conçus pour enregistrer les dates et heures des données des coups de foudre fournies par le dispositif d'horloge (15).

6. Dispositif selon l'une quelconque des revendications précédentes, caractérisé par une unité de lecture séparée (14), dans lequel le dispositif de communication (6, 7) et l'unité de lecture (14) comprennent chacun un dispositif de transmission (7, 8) et de réception (7, 8) pour transférer des données.

7. Dispositif selon la revendication 6, caractérisé en ce que le dispositif de communication (6, 7) et l'unité de lecture (14) sont conçus chacun pour un transfert à distance des données des coups de foudre.

8. Dispositif selon la revendication 6 ou 7, caractérisé en ce que le dispositif de communication (6, 7) et l'unité de lecture (14) sont conçus pour permettre un transfert codé des données enregistrées.

9. Dispositif selon la revendication 6, 7 ou 8, caractérisé en ce que l'unité de lecture (14) contient un circuit de contrôle (11) pour contrôler au moins le transfert des données.

10. Dispositif selon l'une quelconque des revendications précédentes, caractérisé par une source d'alimentation en courant électrique du dispositif (1) connectée au conducteur de coups de foudre (16) et qui se recharge grâce à l'énergie dégagée par les coups de foudre.
